# EUROPEAN PATENT SPECIFICATION

(11) **EP 2 083 406 B1**
(45) Date of publication and mention of the grant of the patent: **28.07.2010**
(21) Application number: 08100890.6
(22) Date of filing: 24.01.2008
(51) Int. Cl.: G08B 21/16

(54) **Electric energy consumption meter with gas detector**
Gerät zur Stromverbrauchsmessung mit Gasdetektor
Mesure de consommation d'énergie électrique avec détecteur de gaz

(43) Date of publication of application: 29.07.2009
(73) Proprietor: KAMSTRUP A/S, 8660 Skanderborg (DK)
(72) Inventor: Drachmann, Jens, 8260 Viby J (DK)
(74) Representative: Sigh, Erik

(56) References cited:
- EP-A- 0 814 444
- EP-A- 0 962 903
- WO-A-00/75902
- DE-U1-202006 001 531
- GB-A- 2 428 806
- US-A1- 2006 103 521
- US-A1- 2007 069 882

## Description

### Field of the invention

The invention relates to the field of electric energy consumption meters.

### Background of the invention

Fire in a building often starts in connection with electric installations in the building. Either due to short circuits in the electric installations or due to flammable gases ignited by sparks from electric installations or due ignited by hot component of the electric installations. Thus, to detect a fire at an early stage, it is normal to install smoke or gas detectors, such as self-contained battery operated smoke alarms, in connection with electric installations.

For example it is known to mount a chloride gas detector close to electric installations so as to quickly detect generation of chloride gas which is generated by electric equipment when heated to more than 70 °C. The chloride gas detector is connected to a power line switch to shuts off electric power to the electric equipment when chloride gas is detected. Hereby, it is possible to prevent fire in the electric equipment, since chloride gas will be generated before the electric equipment starts a fire.

However, such gas detector must be supplied with electric power and in order to be able to communicate an alarm, the gas detector must be connected to a telephone network or the like.

Document De 20 2006001531 U1 discloses an electric consumption meter system with a gas detector in a housing including a common communication module.

### Summary of the invention

Thus, according to the above explanation, it is an object of the present invention to provide a device capable of effectively handling early detection and/or preventing of fire, especially fire related to electric installations.

According to a first aspect, the invention provides an electric consumption meter for measuring an amount of electrical energy delivered by an electric power line, the meter comprising
- a gas detector arranged to sense surrounding air and to generate an alarm signal upon detection of a component in the air exceeding a predetermined threshold, and
- a casing for housing
   - a measuring circuit arranged to measure the amount of electric energy delivered by the electric power line, and to generate a data value representing the measured amount of electric energy, and
   - a receiver circuit arranged to receive the alarm signal from the gas detector.

By 'gas detector' is understood a detector capable of sensing surrounding air with respect to detection of one or more components in the air, such as special gas components, particles etc. Especially, the gas detector may be able to detect smoke. Especially, the gas detector may be able to detect a component selected from: smoke, natural gas, CO₂, NOₓ, SO₂, chloride, and the like. Preferably, the gas detector can detect gases that are caused by fire or more preferably at an early stage before a fire starts, e.g. by detecting gases such as chloride resulting from heated polymeric material, or such as specific gases, e.g. natural gas, which is caused by a leak and which may lead to fire or explosions. The gas detector may in principle be based on any working principle, such as ion detectors, infrared detectors (either non-dispersing or dispersing types) and other types such as known by the skilled person depending on which specific gases or particles in the air which should be detected in a specific case. Thus, the gas detector can be implemented with a low cost standard component.

An electric energy consumption meter according to the first aspect is advantageous for preventing fires and for quickly handling in case fire or smoke has been detected, both in case the gas detector is mounted in or near the meter, i.e. near electric installations where fire often starts. By communicating an alarm signal to the electric meter, the meter has a number of possibilities of handling the alarm, thus allowing improved emergency handling compared to prior art self-contained fire alarm systems.

Many modern electric meters already accommodate a number of facilities which are preferable in relation to detection of fire, preventing fire and alarming in case of fire. E.g. efficient communication capabilities are often already available for meter reading purposes. Such communication facilities are checked regularly and maintained in order to function for reading, and thus there is no need for extra check and service for the extra alarm features. Further, an electric meter provides a reliable power supply, and in case the detection of gas is intended to result in electric power shut down, electric meter with built-in power switches, e.g. remotely controllable power switches, are already known and produced, therefore an extra external and vulnerable power switch component can be avoided - i.e. an extra component being a potential fire source can be eliminated. Further advantages will be described with respect to specific embodiments in the following.

In art related to the invention the gas detector may be arranged within the casing of the meter. Especially, the gas detector may be arranged in connection with an opening in the casing so as to be able to detect gas outside the casing, but the gas detector may also be arranged to detect gas inside the casing. This allows a compact meter which is invulnerable to damage of the link between the receiver circuit in the meter casing and the gas detector. Further, in case the meter has one or more power line switches mounted within the casing, the gas detector will be able to detect over-heating or fire in such power line switch at an early stage.

Especially, at least a part of the gas detector may be mounted on the same circuit board as part of the measuring circuit, such as the gas detector being mounted on the same circuit board as a main digital processor of the meter. More specifically, the casing may houses one single circuit board, and wherein the measuring circuit, the gas detector and the receiver circuit are mounted on this single circuit board.

According to the invention, the gas detector is arranged outside the casing. Hereby, The gas detector may be arranged at other positions where there is a large risk that a fire may start but remote to the meter, such as near natural gas installation or sensitive electric installations. The gas detector may be arranged for wired connection with the receiver circuit. Alternatively, the gas detector includes a transmitter arranged to transmit a wireless alarm signal to the receiver circuit. The gas detector may include a first and a second gas sensor, such as first and second gas sensors sensitive to each specific component in the surrounding air to be detected. E.g. such as chloride gas and smoke particles. Especially, the first gas sensor may be arranged within the casing, while the second gas sensor is arranged outside the casing so as to sense gas inside the casing and outside the casing, respectively.

The meter may further include a power line switch for connecting the electric power line in a first state and for disconnecting the electric power line in a second state, such as a power line switch arranged within the casing. By 'power line switch' is understood a switch capable of handling currents of 50 A or more. Thus, such meter is suited for mounting in dwellings or enterprises for measuring consumed electrical energy delivered to a consumer by the power line. The meter is capable of breaking a power line supply connection of a consumer, e.g. by a control signal provided remotely from an electricity provider. In such embodiments, the receiver circuit is operationally connected to the power line switch to switch the power line switch from the first to the second state in response to the alarm signal from the gas detector. Hereby, electric power can be shut off in case fire or in case there is a high risk of fire, such as a high concentration of natural gas etc. in the air.

In preferred embodiments, the meter includes a communication module connected to the receiver circuit, and arranged to transmit an alarm to an associated external receiver, upon receipt of a signal from the receiver circuit indicating detection of a gas component exceeding a predetermined threshold. Hereby it is possible to communicate fire or risk of fire to a remote receiver that can take action accordingly. The communication module may further be used to transmit the data value representing the measured amount of electric energy, thus utilizing one communication module or circuit both for remote meter reading and alarm signalling.

The communication module may include a wireless Radio Frequency transmitter. Especially such communication module may be arranged to transmit the data value representing the measured amount of electric energy and the alarm on different Radio Frequency frequencies, such as arranged to transmit the alarm on a mobile phone network, while being arranged to transmit the meter data on the ISM net or the like.

The communication module may alternatively or additionally be arranged to communicate via the electric power line, and via a dedicated communication wire.

The meter may include a power supply arranged inside the casing for powering the measuring circuit, an actuator for actuation of a power line switch, the receiver circuit, and the gas detector. Thus, a separate battery or power supply may be saved for the gas detector compared to a stand-alone smoke or fire detectors.

Another possible action to be performed if the gas detector generates an alarm signal, is the action of storing data in a memory in response to receipt of the alarm signal from the gas detector. Thus, even though the meter does not transmit any alarm to a remote receiver, the meter may store e.g. time and type of components detected in response to the alarm signal. This allows later access to such logged data, either by such data being accessible as output messages on a display of the meter, or by remote access to the memory via a communication module in the meter.

Still further actions can be performed if the gas detector generates an alarm signal. The receiver circuit may be connected to activate at least one of: a display arranged in the casing and visible from outside, an acoustic signalling means, an alarm light, in response to receipt of the alarm signal.

It is appreciated that any sub aspect mentioned in connection with the first aspect may in any way be combined with any of the sub aspects of the second aspect.

### Brief description of drawings

In the following, the invention will be described in more details by referring to examples and embodiments illustrated in the accompanying drawings, of which
Fig. 1 illustrates a meter example related to the invention,
Fig. 2 illustrates a meter embodiment,
Fig. 3 illustrates yet another meter example related to the invention, and
Fig. 4 illustrates a side view of a meter casing in which the gas detector is mounted on the same circuit board as other components of the meter.

### Detailed description of the invention

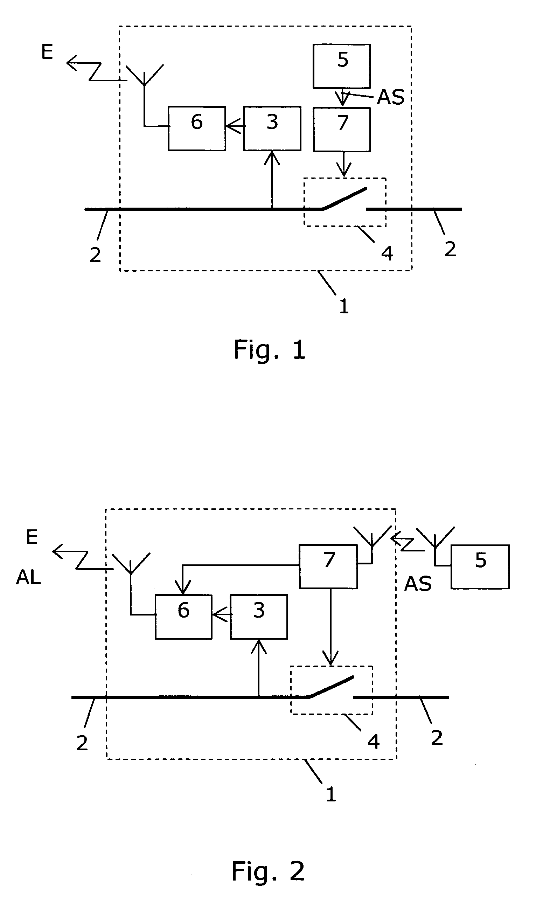

Fig. 1 illustrates an electric energy meter connected to an electric power line 2. Within the meter casing 1 is a meter circuit 3 that determines an amount of consumed energy and applies data representative to this amount to a communication module 6 which includes a Radio Frequency wireless transmitter arranged to wirelessly transmit data E representative of the consumed energy, e.g. in an ISM band or in a GSM band. However, it may be preferred to use specific RF bands outside the ISM and GSM bands.

A gas detector 5, e.g. a smoke detector, is positioned within the casing 1, and the gas detector 5 is connected to a receiver circuit 7 which receives an electric alarm signal AS from the gas detector 5, in case the gas detector 5 determines a component, e.g. indicative of smoke, in the surrounding air. In the illustrated embodiment, the gas detector 5 is positioned inside the casing 1, and it may thus be able to detect e.g. smoke inside the electric meter. However, via an opening in the casing, the gas detector 5 may likewise be able to sense air surrounding the casing. The receiver circuit 7 is connected to control a power line switch 4 such that the power line 2 is disconnected in case the gas detector 5 detects e.g. smoke. Hereby, electric power is automatically cut off for an electric device which may have caused a fire, thus preventing further damage, or possibly preventing a fire by disconnecting electric power at an early state where e.g. a short-circuit in a device has only emitted smoke or other components in the air but not yet broken into fire. Since the gas detector 5 is mounted inside the meter casing 1, the gas detector can be supplied with electric power from the meter instead of by a battery which may however be used as a back-up supply.

Fig. 2 illustrates another embodiment. Here, the gas detector 5 positioned outside the meter casing 1 and connected to the receiver circuit 7 wirelessly, e.g. by a wireless Radio Frequency (RF) connection such as Bluetooth or any other known RF connection suited for the actual distance between the gas detector 5 and the electric meter. Functionally, the gas detector 5 still sends a wireless alarm signal AS to the receiver circuit, as in Fig. 1, when the gas detector 5 detects e.g. smoke. In this embodiment, the gas detector 5 can be placed independent of the electric meter, e.g. near a possible source of fire so as to catch a sign of fire at an early state.

In the embodiment of Fig. 2, the receiver circuit is, as in Fig. 1, coupled to disconnect a power line switch 4, upon receipt of the alarm signal AS from the gas detector 5. Further, the receiver circuit 7 is coupled to the wireless communication module 6 that is capable of transmitting data E representing the amount of consumed energy as well as a wireless alarm AL, in case the gas detector detects e.g. smoke. The wireless alarm signal AL can e.g. be used to call a local fire department, and/or other service personnel.

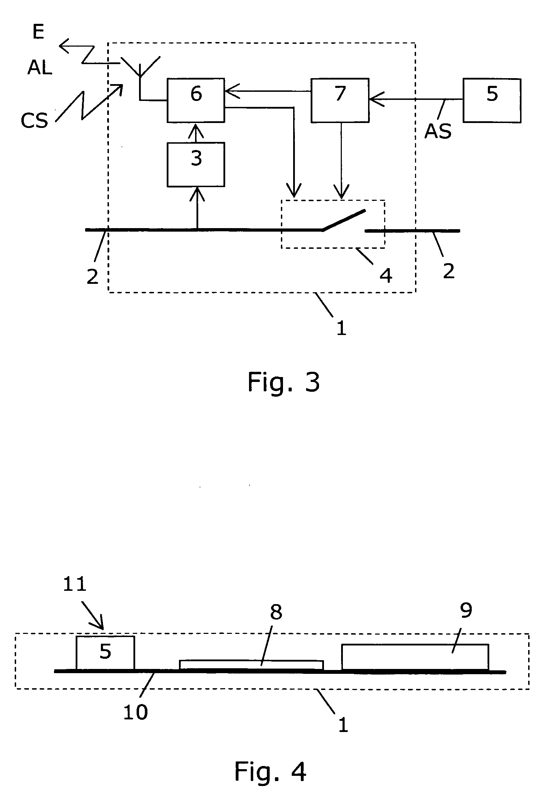

Fig. 3 illustrates a meter embodiment with a gas detector 5 positioned outside the meter casing 1 and in wired contact with the receiver circuit 7. The wire connecting the gas detector 5 may further be used for powering the gas detector 5 from the meter. In the embodiment of Fig. 3, the wireless RF communication module 6 can transmit data E representing the amount of consumed energy, and an alarm AL in case the gas detector detects e.g. smoke. Further, the wireless RF communication module 6 can receive a wireless signal CS e.g. from electricity provider, indicating that the power line 2 to the specific consumer should be disconnected. Thus, the communication module 6 is connected to the power line switch 4 to disconnect the power line 2 in response to receiving such signal CS.

Fig. 4 illustrates schematically a section of an electric meter embodiment with position of different components inside the casing 1. One single printed circuit board 10 inside the casing 1 carries the gas detector 5, a cluster of components 8 including receiver circuit and communication module, and a second cluster 9 of components including measuring circuit for measuring the amount of electric energy. An opening 11 in the casing aligned with the gas detector 5 may be provided so as to make the gas detector 5 sensitive to air outside the meter casing 1. A compact meter can be obtained by mounting all electronic components on one single circuit board 10 with all meter functions and gas detector functions integrated. One single power supply can be used to power the meter circuit and the gas detector 5.

It is appreciated that the gas detector can in principle be any known type of gas detector that can be used to detect smoke, and/or any specific type of gas leak or liquid leak that may cause detectable components or particles in the surrounding air. Thus, apart from combining the function of an electric meter and a fire alarm, the electric meter according to the invention also has applications as part of alarm systems for other types of malfunctions or emergency situations.

To sum up, the invention provides an electric consumption meter for measuring an amount of electrical energy delivered by an electric power line. The meter includes a gas detector arranged to sense surrounding air and to generate an electric alarm signal upon detection of a component in the air, e.g. smoke particles. Inside a meter casing, the meter has a measuring circuit arranged to measure the amount of electric energy delivered by the electric power line, and a receiver circuit arranged to receive the alarm signal from the gas detector. The gas detector may be placed inside or outside the meter casing. If placed outside the meter casing, the gas detector and the receiver circuit may be wired or wirelessly interconnected. The receiver circuit may control a power line switch so as to disconnect electric power in case an alarm signal is received. Alternatively or additionally, the receiver circuit may be connected to a communication module arranged for wired or wireless communication of an alarm signal, e.g. a smoke or fire alarm, in case the gas detector has detected a component in the air exceeding a predetermined threshold.

Although the present invention has been described in connection with the specified embodiments, it is not intended to be limited to the specific form set forth herein. Rather, the scope of the present invention is limited only by the accompanying claims. In the claims, the term "comprising" or "including" does not exclude the presence of other elements. Additionally, although individual features may be included in different claims, these may possibly be advantageously combined, and the inclusion in different claims does not imply that a combination of features is not feasible and/or advantageous. In addition, singular references do not exclude a plurality. Thus, references to "a", "an", "first", "second" etc. do not preclude a plurality. Furthermore, reference signs in the claims shall not be construed as limiting the scope.

## Claims

1. An electric consumption meter system for measuring an amount of electrical energy delivered by an electric power line (2), the meter system comprising
- a gas detector (5) arranged to sense surrounding air and to generate an alarm signal (AS) upon detection of a component in the air exceeding a predetermined threshold, and
- a casing (1) for housing
- a measuring circuit (3) arranged to measure the amount of electric energy delivered by the electric power line (2), and to generate a data value (E) representing the measured amount of electric energy, and
- a receiver circuit (7) arranged to receive the alarm signal (AS) from the gas detector (5),
wherein the gas detector (5) is arranged outside the casing (1), the gas detector (5) including a transmitter arranged to transmit a wireless alarm signal (AS) upon detection of a gas component exceeding a predetermined threshold, and wherein the receiver circuit (7) is arranged to receive the wireless alarm signal (AS), and
wherein the meter includes a communication module (6) connected to the receiver circuit (7), and arranged to transmit an alarm (AL) to an associated external receiver, in response to a signal from the receiver circuit (7) indicating detection of a gas component exceeding a predetermined threshold, and wherein the communication module (6) is further arranged to transmit the data value (E) representing the measured amount of electric energy to an associated external receiver.

2. Meter system according to any of the preceding claims, wherein the gas detector (5) includes a first and a second gas sensor.

3. Meter system according to any of the preceding claims, further including a power line switch (4) for connecting the electric power line (2) in a first state and for disconnecting the electric power line (2) in a second state.

4. Meter system according to claim 3, wherein the power line switch (4) is arranged within the casing (1).

5. Meter system according to claim 3 or 4, wherein the receiver circuit (7) is operationally connected to the power line switch (4) to switch the power line switch (4) from the first to the second state in response to the alarm signal (AS) from the gas detector (5).

6. Meter system according to claim 5, including a plurality of power line switches (4) operationally to the receiver circuit (7) so as to disconnect respective electric phases of the power line (2) in response to the gas detector (5) detecting a gas component exceeding a predetermined threshold.

7. Meter system according to any of the preceding claims, wherein the communication module (6) includes a wireless Radio Frequency transmitter.

8. Meter system according to claim 7, wherein the communication module (6) is arranged to transmit the data value (E) representing the measured amount of electric energy and the alarm (AL) on different Radio Frequency frequencies.

9. Meter system according to any of the preceding claims, wherein the communication module (6) is arranged to transmit the alarm (AL) on a mobile phone network.

10. Meter system according to any of the preceding claims, wherein the communication module (6) is arranged to communicate via the electric power line (2).

11. Meter system according to any of the preceding claims, wherein the communication module (6) is arranged to communicate via a dedicated communication wire.

12. Meter system according to any of the preceding claims, including a memory, wherein the receiver circuit (7) is arranged to store data in the memory in response to receipt of the alarm signal (AS) from the gas detector (5).

13. Meter system according to any of the preceding claims, wherein the receiver circuit (7) is connected to activate at least one of: a display arranged in the casing (1) and visible from outside, an acoustic signalling means, an alarm light, in response to receipt of the alarm signal (AS) from the gas detector (5).

14. Meter system according to any of the preceding claims, where the gas detector (5) is arranged to generate the alarm signal (AS) in response to detecting at least one component selected from: smoke, natural gas, CO₂, NOₓ, SO₂, and chloride.

## Patentansprüche

1. Elektrisches Verbrauchsmesssystem zum Messen der Menge an elektrischer Energie, die von einer Stromleitung (2) abgegeben wird, wobei das Messsystem umfasst
- einen Gasdetektor (5), der derart eingerichtet ist, dass die Umgebungsluft registriert wird und beim Detektieren einer Komponente in der Luft, die einen vorbestimmten Schwellenwert überschreitet, ein Alarmsignal (AS) hervorgebracht wird, und
- ein Gehäuse (1) zur Aufnahme
- eines Messkreises (3), der derart eingerichtet ist, dass die Menge an elektrischer Energie, die von einer Stromleitung (2) abgegeben wird, gemessen und ein Datenwert (E) erzeugt wird, der die gemessene Menge an elektrischer Energie darstellt, und
- eines Empfangskreises (7), der derart eingerichtet ist, dass das Alarmsignal (AS) aus dem Gasdetektor (5) empfangen wird,
wo der Gasdetektor (5) auf der Außenseite des Gehäuses (1) angeordnet ist, der Gasdetektor (5) einen Sender umfasst, der eingerichtet ist, um ein drahtloses Alarmsignal (AS) beim Detektieren einer Gaskomponente, die einen vorbestimmten Schwellenwert überschreitet, zu senden, und wo der Empfangskreis (7) eingerichtet ist, um ein drahtloses Alarmsignal (AS) zu empfangen, und
wo der Messer ein Kommunikationsmodul (6) umfasst, das mit dem Empfangskreis (7) verbunden und derart eingerichtet ist, um als Reaktion auf ein Signal aus dem Empfangskreis (7), das Detektion einer Gaskomponente, die einen vorbestimmten Schwellenwert überschreitet, angibt, einen Alarm (AL) an einen verknüpften externen Empfänger zu senden, und wo das Kommunikationsmodul (6) weiterhin eingerichtet ist, um den Datenwert (E), der die gemessene Menge an elektrischer Energie bezeichnet, an einen verknüpften externen Empfänger zu senden.

2. Messsystem nach einem der vorhergehenden Ansprüche, wo der Gasdetektor (5) einen ersten und einen zweiten Gassensor umfasst.

3. Messsystem nach einem der vorhergehenden Ansprüche, das weiterhin einen Netzschalter (4) umfasst zum Verbinden der Stromleitung (2) in einem ersten Zustand und zum Unterbrechen der Stromleitung (2) in einem zweiten Zustand.

4. Messsystem nach Anspruch 3, wo der Netzschalter (4) innerhalb des Gehäuses (1) angeordnet ist.

5. Messsystem nach Anspruch 3 oder 4, wo der Empfangskreis (7) betrieblich mit dem Netzschalter (4) verbunden ist, um den Netzschalter (4) als Reaktion auf das Alarmsignal (AS) aus dem Gasdetektor (5) vom ersten auf den zweiten Zustand umzuschalten.

6. Messsystem nach Anspruch 5, umfassend eine Mehrheit von Netzschaltern (4), die betrieblich mit dem Empfangskreis (7) verbunden sind, um jeweilige elektrische Phasen der Stromleitung (2) zu unterbrechen als Reaktion auf das Detektieren einer Gaskomponente, die einen vorbestimmten Schwellenwert überschreitet, durch den Gasdetektor (5).

7. Messsystem nach einem der vorhergehenden Ansprüche, wo das Kommunikationsmodul (6) einen drahtlosen Hochfrequenzsender umfasst.

8. Messsystem nach Anspruch 7, wo das Kommunikationsmodul (6) eingerichtet ist, um den Datenwert (E), der die gemessene Menge an elektrischer Energie bezeichnet, und den Alarm (AL) auf verschiedene HF-frequenzen zu senden.

9. Messsystem nach einem der vorhergehenden Ansprüche, wo das Kommunikationsmodul (6) eingerichtet ist, um den Alarm (AL) über ein Mobilfunknetz zu senden.

10. Messsystem nach einem der vorhergehenden Ansprüche, wo das Kommunikationsmodul (6) eingerichtet ist, um über die Stromleitung (2) zu kommunizieren.

11. Messsystem nach einem der vorhergehenden Ansprüche, wo das Kommunikationsmodul (6) eingerichtet ist, um über eine geeignete Kommunikationsleitung zu kommunizieren.

12. Messsystem nach einem der vorhergehenden Ansprüche, umfassend einen Datenspeicher, wo der Empfangskreis (7) eingerichtet ist, um als Reaktion auf den Empfang eines Alarmsignals (AS) aus dem Gasdetektor (5) Daten im Datenspeicher zu speichern.

13. Messsystem nach einem der vorhergehenden Ansprüche, wo der Empfangskreis (7) angeschlossen ist, um mindestens eins der folgenden als Reaktion auf den Empfang eines Alarmsignals (AS) aus dem Gasdetektor (5) zu aktivieren: ein Display, das im Gehäuse (1) angeordnet ist und von der Außenseite sichtbar ist, ein akustisches Signalmittel und ein Alarmlicht.

14. Messsystem nach einem der vorhergehenden Ansprüche, wo der Gasdetektor (5) eingerichtet ist, um den Alarmsignal (AS) als Reaktion auf das Detektieren mindestens einer der folgenden Komponenten: Rauch, Erdgas, CO₂, NOₓ, SO₂ und Chlorid hervorzubringen.

## Revendications

1. Système de compteur de consommation électrique destiné à mesurer une quantité d'énergie électrique fournie par une ligne d'alimentation électrique (2), le système de compteur comprenant
- un détecteur de gaz (5) disposé pour analyser l'air environnant et pour générer un signal d'alarme (AS) en cas de détection dans l'air d'un composant dépassant un seuil prédéterminé, et
- un boîtier (1) destiné à contenir
- un circuit de mesure (3) disposé pour mesurer la quantité d'énergie électrique fournie par la ligne d'alimentation électrique (2) et pour générer une valeur de donnée (E) représentant la quantité mesurée d'énergie électrique, et
- un circuit de réception (7) disposé pour recevoir le signal d'alarme (AS) du détecteur de gaz (5),
dans lequel le détecteur de gaz (5) est disposé à l'extérieur du boîtier (1), le détecteur de gaz (5) incluant un transmetteur disposé pour transmettre un signal d'alarme (AS) sans fil en cas de détection d'un composant gazeux dépassant un seuil prédéterminé, et dans lequel le circuit de réception (7) est disposé pour recevoir le signal d'alarme (AS) sans fil, et
dans lequel le compteur inclut un module de communication (6) raccordé au circuit de réception (7) et disposé pour transmettre une alarme (AL) à un récepteur externe associé, en réponse à un signal du circuit de réception (7) indiquant la détection d'un composant gazeux dépassant un seuil prédéterminé, et dans lequel le module de communication (6) est également disposé pour transmettre la valeur de donnée (E) représentant la quantité mesurée d'énergie électrique à un récepteur externe associé.

2. Système de compteur selon l'une quelconque des revendications précédentes, dans lequel le détecteur de gaz (5) inclut un premier et un deuxième capteur de gaz.

3. Système de compteur selon l'une quelconque des revendications précédentes, incluant également un commutateur de ligne électrique (4) pour connecter la ligne d'alimentation électrique (2) dans un premier état et pour déconnecter la ligne d'alimentation électrique (2) dans un deuxième état.

4. Système de compteur selon la revendication 3, dans lequel le commutateur de ligne électrique (4) est disposé dans le boîtier (1).

5. Système de compteur selon la revendication 3 ou 4, dans lequel le circuit de réception (7) est raccordé de façon opérationnelle au commutateur de ligne électrique (4) pour commuter le commutateur de ligne (4) du premier au deuxième état en réponse au signal d'alarme (AS) du détecteur de gaz (5).

6. Système de compteur selon la revendication 5, incluant plusieurs commutateurs de ligne électrique (4) raccordés de façon opérationnelle au circuit de réception (7) de manière à déconnecter les phases électriques respectives de la ligne électrique (2) en réponse à la détection par le détecteur de gaz (5) d'un composant gazeux dépassant un seuil prédéterminé.

7. Système de compteur selon l'une quelconque des revendications précédentes, dans lequel le module de communication (6) inclut un transmetteur radioélectrique sans fil.

8. Système de compteur selon la revendication 7, dans lequel le module de communication (6) est disposé pour transmettre la valeur de donnée (E) représentant la quantité mesurée d'énergie électrique et l'alarme (AL) sur différentes fréquences radioélectriques.

9. Système de compteur selon l'une quelconque des revendications précédentes, dans lequel le module de communication (6) est disposé pour transmettre l'alarme (AL) sur un réseau de téléphonie mobile.

10. Système de compteur selon l'une quelconque des revendications précédentes, dans lequel le module de communication (6) est disposé pour communiquer par l'intermédiaire de la ligne d'alimentation électrique (2).

11. Système de compteur selon l'une quelconque des revendications précédentes, dans lequel le module de communication (6) est disposé pour communiquer par l'intermédiaire d'un fil de communication dédié.

12. Système de compteur selon l'une quelconque des revendications précédentes, incluant une mémoire, dans lequel le circuit de réception (7) est disposé pour stocker des données dans la mémoire en réponse à la réception du signal d'alarme (AS) du détecteur de gaz (5).

13. Système de compteur selon l'une quelconque des revendications précédentes, dans lequel le circuit de réception (7) est raccordé de manière à activer au moins l'un des éléments suivants : un afficheur disposé dans le boîtier (1) et visible de l'extérieur, un moyen de signalisation acoustique, une alarme lumineuse, en réponse à la réception du signal d'alarme (AS) du détecteur de gaz (5).

14. Système de compteur selon l'une quelconque des revendications précédentes, dans lequel le détecteur de gaz (5) est disposé pour générer le signal d'alarme (AS) en réponse à la détection d'au moins un composant choisi parmi : fumée, gaz naturel, CO₂, NOₓ, SO₂ et chlorure.
